Europäisches Patentamt

European Patent Office

Office européen des brevets

(19)

(11) Publication number: **0 257 414**
**A2**

(12) **EUROPEAN PATENT APPLICATION**

(21) Application number: **87111494.8**

(22) Date of filing: **08.08.87**

(51) Int. Cl.⁴: **H03M 13/00**

(30) Priority: **22.08.86 US 899470**

(43) Date of publication of application:
**02.03.88 Bulletin 88/09**

(84) Designated Contracting States:
**DE FR GB**

(71) Applicant: **Hewlett-Packard Company**
**P.O. Box 10301 3000 Hanover Street**
**Palo Alto California 94303-0890(US)**

(72) Inventor: **Worley, William S., Jr.**
**18316 Falmouth Court**
**Saratoga California 95070(US)**

(74) Representative: **Patentanwälte Kohler -**
**Schwindling - Späth**
**Hohentwielstrasse 41**
**D-7000 Stuttgart 1(DE)**

(54) **Fast error detection/correction for command signals.**

(57) A method of detecting and correcting errors in a
transmitted digital command is provided. The com-
mand desired to be transmitted is encoded to pro-
vide a coded transmission representative of the de-
sired command. The coded transmission is com-
pared with a mapping of possible error occurring in
transmission. If the comparison produces a match,
then the coded transmission is identified as the
desired command.

EP 0 257 414 A2

READ ──────
WRITE ──────  ┌────────┐
INTER ──────  │  CODE  │ ──────────▶  ┌────────┐ ────── READ
SEMA ──────   │        │              │        │ ────── WRITE
              └────────┘              │        │ ────── INTER
                                      └────────┘ ────── SEMA

*FIG 3*

## FAST ERROR DETECTION/CORRECTION FOR COMMAND SIGNALS

### Field of the Invention

The present invention relates to the detection and correction of errors which may occur in the transmission of digital commands.

### Discussion of the Prior Art

Whenever digital information is transmitted from one location to another, there is a possibility for error due either to device failure or noise.

There are a number of ways to handle such errors. Some systems request re-transmission of the information if an error is detected. In other systems, re-transmission may be impossible or prohibitively expensive. In systems of the latter type, the receiving equipment must be able not only to detect an error, but also to correct it.

Error detection techniques rely on the transmission of redundant information. This requires that additional bits of data be transmitted, resulting in lower overall efficiency of transmission. In parallel error detection systems, additional elements such as wires, transmitters and receivers are required. In serial systems, additional time is used to transmit the redundant information.

None of the known detection/correction methods can completely eliminate errors. However, as the percentage of redundant bits or the sophistication of the error detection/correction algorithm increases, the probability of undetected or uncorrected errors decreases.

The simplest and most common method of handling digital transmission errors is to add a single extra bit to the transmitted word. This extra bit, called a parity bit, is chosen t be "1" or a "0" such that the total number of "1's" in the transmitted word (counting the parity bit) is odd ( an "odd" parity system) or even (an "even" parity system). Odd parity is generally preferred because it insures at least one "1" in any word. The transmitted parity word is examined at the receiving end to determine if the parity number of the transmitted word has changed. If there has been a change, the detector identifies wrong parity.

The problem with single bit parity checking is that provides only single bit error detection. If an even number or errors occurs, parity checking cannot detect it. Nor can parity checking correct erroneous transmissions.

It is, of course, possible to add more than one bit of redundant information to transmitted digital information, formulating the redundant bits such that errors are not only detected but also corrected. A word containing an error-correcting field of redundant information is called a Hamming code. A Hamming code uses several parity bits which are generated and arranged such that a unique set of parity errors results from an error in any given bit position. In general, a Hamming code contains 2M-1 bits, m of which are the Hamming bits and 22-m-1 are the information bits.

A major deficiency of Hamming codes is the need for extensive logic circuitry for checking and correcting the transmitted data. In addition, the checking and correcting procedure requires an undesirably long period of time.

Furthermore, the error detection/correction techniques described above in the past been applied only to digital data transmissions. No technique has been provided for correcting errors which may occur in the transmission of digital commands.

### Summary of the Invention

It is an object of the present invention to detect and correct errors in transmitted digital commands utilizing minimal logic circuitry.

It is an object of the present invention to provide a method for detecting and correcting errors in the transmission of digital commands in a reasonable period of time.

These and other objects of the invention are accomplished by providing a method of detecting and correcting errors occurring in the transmission of digital commands wherein the digital command is statically encoded to provide a coded transmission which is representative of the desired command. The coded transmission is then compared with a mapping of possible erroneous transmissions. If the comparison produces a match, then the coded transmission is identified to be the desired command.

### Description of the Drawings

Figure 1 is a schematic block diagram illustrating a prior art method of detecting and correcting errors in digital data transmission;

Figure 2A is a table which illustrates the coding of a single bit data word for detection and correction of errors in transmission;

Figure 2B is a schematic logic diagram illustrating the logic required to check and correct a single bit data transmission; and

Figure 3 is a schematic block diagram illustrating the correction of command messages in accordance with the present invention.

## Detailed Description of the Preferred Embodiment

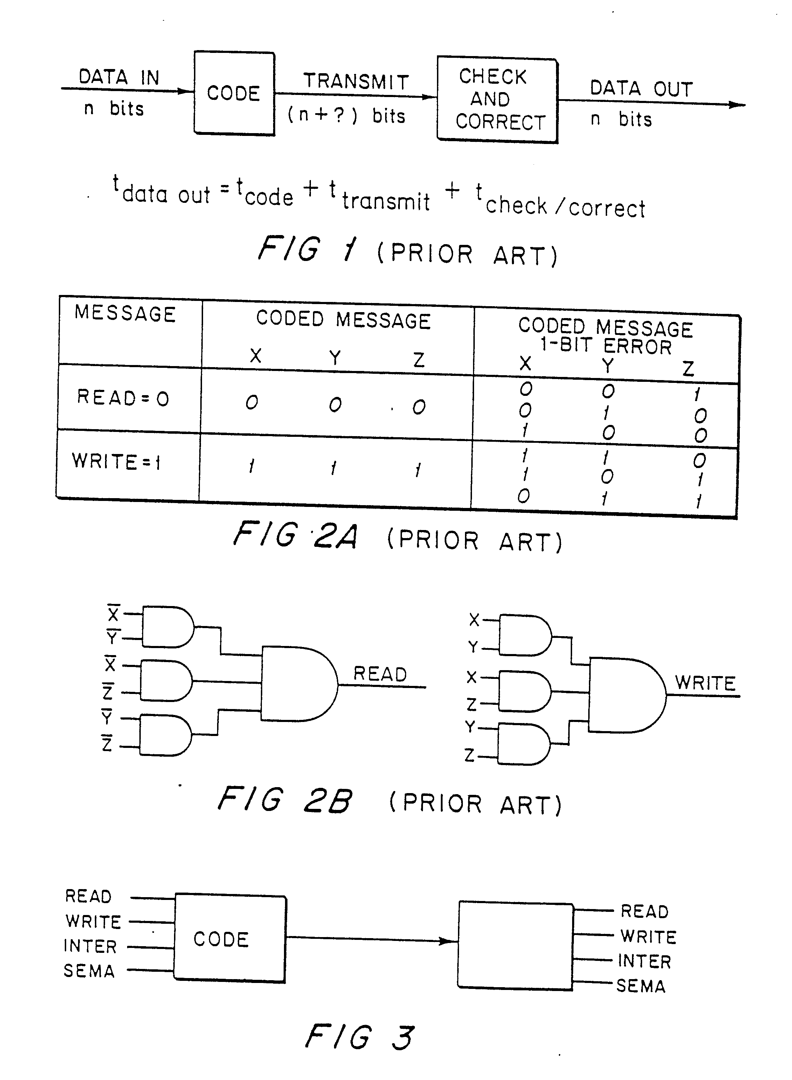

Figure 1 shows the prior art technique of using Hamming Code to detect and correct errors which may occur in the transmission of digital data.

According to this technique, a stream of data bits is coded and then transmitted. The coded transmitted data is received by check/correct logic which checks the transmitted data stream for errors and, in the event that errors are detected, corrects the error to provide the desired data for use.

The time between generation of data to be transmitted and its receipt for use in the sum of the time required to code the data plus the time required to transmit the coded data plus the time required to check and correct the coded data. For data streams utilizing a large number of bits (32 bit data messages are common), the check/correct logic can be extensive and can introduce a substantial time delay between the generation of the data and its ultimate use.

Figures 2A and 2B illustrate and example of the prior art technique of detecting and correcting errors in the transmission of a simple single bit data message, either 0 or 1. The data is coded to be a 2-bit word wherein $0 = 0000$ and $1 = 1111$. This technique allows for single bit error detection/correction, wherein Figure 2A lists the possible transmissions, utilizing the check/correct logic shown in Figure 2b. It can be seen that the check/correct logic for transmission of longer data words would be quite extensive and would introduce a substantial time delay between generation of the data to be transmitted and its use.

Heretofore, the above-mentioned error detection/correction technique has been utilized only in the transmission of digital data. No method has been provided for detecting and correcting errors occurring in the transmission of digital commands. The present invention provides an error detection/correction method which is applicable to both commands and data.

Figure 3 illustrates the command detection/correction technique of the present invention. A command to be transmitted is coded, for instance by a distance $2n + 1$ coding, and transmitted. In a distance $2n + 1$ coding up to n bit errors in a coded command can be corrected. Each coded command differs from every other coded command by at least $2n + 1$ bits.

The coded transmission message is received by a decoder block which accepts either the command code, or any code resulting from a 1,2,...,n bit error to the original code, as equivalent encodings of the desired command. One embodiment could be a decoder which associatively compares a received coded transmission message with a predetermined table which maps all potential errors which could result in the transmission of the desired command. If there is a match in the table, then the transmitted message is identified as the desired command.

Figure 3 illustrates an example of the transmission of a two bit command in accordance with the present invention. Four commands are possible: READ (00), WRITE (01), INTERRUPT (10) and SEMAPHONE (11). Assuming that the command to be transmitted is a READ, i.e., 00, the READ command is coded to be the following six bit word: 000001. A one bit error in the transmitted READ message would then be among the following possibilities: 000000, 100001, 010001, 001001, 000101, and 000011. The decoder logic accepts any of the preceeding six bit words as equivalent encodings of the READ command. For instance, the decoder logic may compare the transmitted six bit word against any of the six acceptable possibilities. If there is a match, then the transmitted word is interpreted as being the READ command.

The foregoing technique eliminates the need for any check/correct logic normally required to transmit the command and results faster execution.

## Claims

1. A method of detecting and correcting errors in a transmitted digital command, the method comprising:

encoding the desired command to provide a coded transmission representative of the desired command;

comparing the coded transmission with a mapping of possible erroneous transmissions; and

if the comparison produces a match, identifying the coded transmission as the desired command.

2. A method of detecting and correcting up to n-bit errors in a transmitted digital command, the method comprising:

encoding the desired command in a distance $2n + 1$ code to provide a coded transmission representative of the desired command;

accepting as equivalent encodings any of zero to n-bit encodings of the coded transmission representative of the desired command;

$$t_{\text{data out}} = t_{\text{code}} + t_{\text{transmit}} + t_{\text{check/correct}}$$

FIG 1 (PRIOR ART)

| MESSAGE | CODED MESSAGE | | | CODED MESSAGE 1-BIT ERROR | | |
|---|---|---|---|---|---|---|
| | X | Y | Z | X | Y | Z |
| READ = 0 | 0 | 0 | 0 | 0<br>0<br>1 | 0<br>1<br>0 | 1<br>0<br>0 |
| WRITE = 1 | 1 | 1 | 1 | 1<br>1<br>0 | 1<br>0<br>1 | 0<br>1<br>1 |

FIG 2A (PRIOR ART)

FIG 2B (PRIOR ART)

FIG 3